(19) **Europäisches Patentamt / European Patent Office / Office européen des brevets**

(11) **EP 3 859 768 A1**

(12) **EUROPEAN PATENT APPLICATION**
published in accordance with Art. 153(4) EPC

(43) Date of publication:
04.08.2021 Bulletin 2021/31

(21) Application number: 19865092.1

(22) Date of filing: 24.09.2019

(51) Int Cl.:
*H01L 21/304* (2006.01)          *B24B 37/00* (2012.01)
*C09G 1/02* (2006.01)          *C09K 3/14* (2006.01)

(86) International application number:
PCT/JP2019/037362

(87) International publication number:
WO 2020/067057 (02.04.2020 Gazette 2020/14)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 28.09.2018   JP 2018185526
28.03.2019   JP 2019062384

(71) Applicant: Fujimi Incorporated
Kiyosu-shi, Aichi 452-8502 (JP)

(72) Inventors:
• HIRAKO, Sachiko
  Kiyosu-shi, Aichi 452-8502 (JP)
• NOGUCHI, Naoto
  Kiyosu-shi, Aichi 452-8502 (JP)

(74) Representative: Grünecker Patent- und
Rechtsanwälte
PartG mbB
Leopoldstraße 4
80802 München (DE)

(54) **COMPOSITION FOR POLISHING GALLIUM OXIDE SUBSTRATE**

(57)    Provided are a polishing composition capable of achieving both a high polishing removal rate and high surface quality in polishing a gallium oxide substrate, and a method for polishing and a method for manufacturing a gallium oxide substrate using the polishing composition. According to the art disclosed herein, provided is a polishing composition used for polishing a gallium oxide substrate. This polishing composition contains abrasive and water. By polishing with such a polishing composition, it is possible to improve the polishing removal rate for the gallium oxide substrate and realize a gallium oxide substrate having good surface quality.

[Fig. 1]

## Description

### Technical Field

The present invention relates to a polishing composition, and more particularly to a polishing composition used for polishing gallium oxide substrates. This application claims priority based on Japanese Patent Application No. 2018-185526 filed on September 28, 2018 and Japanese Patent Application No. 2019-062384 filed on March 28, 2019. The entire contents of those applications are incorporated herein by reference.

### Background Art

For example, oxides such as aluminum oxide (typically sapphire), silicon oxide, gallium oxide, and zirconium oxide, nitrides such as aluminum nitride, silicon nitride, and gallium nitride, and carbides such as silicon carbide are known as materials for compound semiconductor substrates such as substrates for optical devices and substrates for power devices.

### Summary of Invention

Technical Problem

Among the compound semiconductor substrates described above, the gallium oxide substrate has advantages such as high durability and easy crystal growth as compared with substrates made of other materials. However, the gallium oxide substrate is still in the research stage. In particular, the polishing processing technology for flattening and smoothing the substrate has not been established.

Accordingly, an object of the present invention is to provide a polishing composition capable of achieving both a high polishing removal rate and high surface quality in polishing a gallium oxide substrate. Another related object is to provide a method for polishing and a method for manufacturing a gallium oxide substrate using the polishing composition. Solution to Problem

According to this description, provided is a polishing composition used for polishing a gallium oxide substrate. This polishing composition includes abrasive and water. By polishing with such a polishing composition, it is possible to improve the polishing removal rate for the gallium oxide substrate and realize good surface quality.

In a preferred embodiment of the polishing composition disclosed herein, the abrasive include at least one selected from the group consisting of silica and alumina. By using silica or alumina as the abrasive, the gallium oxide substrate can be suitably polished.

In a preferred embodiment of the polishing composition disclosed herein, an average primary particle diameter of the abrasive is 5 nm or larger. With the polishing composition including abrasive having such an average primary particle diameter, it is easy to improve the polishing removal rate.

In a preferred embodiment of the polishing composition disclosed herein, the average primary particle diameter of the abrasive is 1000 nm or smaller. By polishing with the polishing composition including abrasive having such an average primary particle diameter, good surface quality can be easily obtained.

In a preferred embodiment of the polishing composition disclosed herein, an average secondary particle diameter of the abrasive is 10 nm or larger. With the polishing composition including abrasive having such an average secondary particle diameter, it is easy to improve the polishing removal rate.

In a preferred embodiment of the polishing composition disclosed herein, the average secondary particle diameter of the abrasive is 1500 nm or smaller. By polishing with the polishing composition including abrasive having such an average secondary particle diameter, good surface quality can be easily obtained.

A preferred embodiment of the polishing composition disclosed herein further includes an acid. The acid can be contained in the polishing composition as a component for pH adjustment and the like.

Further, the acid preferably includes at least one selected from the group consisting of nitric acid, hydrochloric acid, chloric acid, and bromic acid. By polishing with a polishing composition including these acids, good surface quality can be easily obtained.

In a preferred embodiment of the polishing composition disclosed herein, the pH of the polishing composition is 4.0 or higher and lower than 12.0. By polishing using such a polishing composition, a gallium oxide substrate can be advantageously polished.

In some embodiments of the polishing composition disclosed herein, the acid preferably includes phosphoric acid. For example, it is preferable that the acid include phosphoric acid and the pH be 0.5 or higher and lower than 8. By polishing using such a polishing composition, a gallium oxide substrate can be advantageously polished.

Further, according to this description, a method for polishing a gallium oxide substrate is provided. This polishing method includes supplying any of the polishing compositions disclosed herein to a substrate to be polished to polish the substrate. With such a method for polishing a gallium oxide substrate, it is possible to achieve both a polishing removal rate and surface quality.

In addition, according to this description, a method for manufacturing a gallium oxide substrate is provided. This manufacturing method includes a polishing step of supplying any of the polishing compositions disclosed herein to a substrate to be polished and polishing the substrate. According to such a manufacturing method, a gallium oxide substrate having good surface quality can be efficiently obtained.

**Brief Description of Drawings**

[Fig. 1]

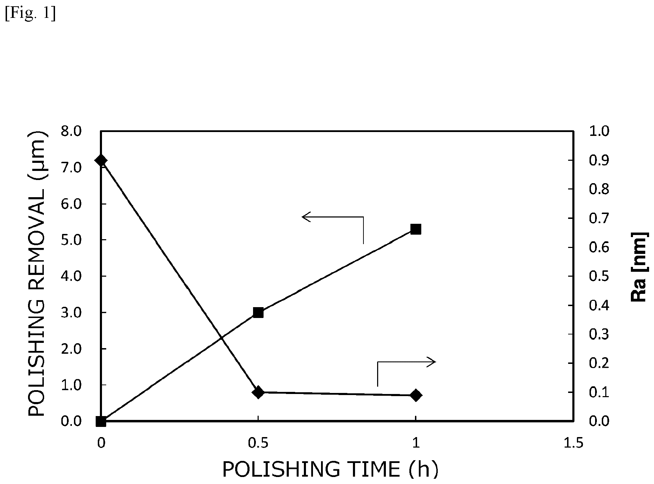

Fig. 1 is a graph showing the measurement results of a polishing removal and a surface roughness (Ra) in Experiment C.

**Description of Embodiments**

Hereinafter, preferred embodiments of the present invention will be described. Matters other than those specifically mentioned in the present description and necessary for carrying out the present invention can be understood as design matters for a person skilled in the art which are based on the related art in the pertinent field. The present invention can be carried out based on the contents disclosed in the present description and common technical knowledge in the pertinent field.

<Object to Be Polished>

The polishing composition disclosed herein is used for polishing a gallium oxide substrate. The gallium oxide substrate is a substrate substantially made of gallium oxide ($Ga_2O_3$). There are five forms of gallium oxide having different structures of $\alpha$, $\beta$, $\gamma$, $\delta$, and $\varepsilon$, and monoclinic crystal $\beta$-$Ga_2O_3$, which is the most stable structure, is typically used. Further, the gallium oxide substrate may include an impurity element in addition to the gallium oxide single crystal. This impurity element can be, for example, an element doped for controlling conductivity or the like. Further, the gallium oxide substrate may have a layer substantially made of gallium oxide formed on an appropriate base layer. Examples of such a base layer include a sapphire substrate, a silicon substrate, a SiC substrate, and the like.

In the present description, "substantially made of X" or "substantially composed of X" with respect to the composition of the substrate means that the ratio of X to the substrate (purity of X) is 90% or more (preferably 95% or more, more preferably 97% or more, still more preferably 98% or more, for example 99% or more) based on the weight.

Although not particularly limited, the surface (face to be polished) of the gallium oxide substrate may be a surface other than the (100) plane, for example, a (-201) plane, a (101) plane, or a (001) plane. For example, the Vickers hardness on the (-201) plane of the gallium oxide substrate is about 12.5 GPa, and the Vickers hardness on the (101) plane is about 9.7 GPa.

<Polishing Composition>

(Abrasive)

The polishing composition for a gallium oxide substrate disclosed herein includes abrasive. By polishing with such a polishing composition, it is possible to improve the polishing removal rate for the gallium oxide substrate and realize good surface quality. The abrasive can be selected for use, as appropriate, from among the abrasive that can be used for polishing other compound semiconductor substrates. Abrasive can be exemplified by abrasive substantially composed of an oxide such as silicon oxide (silica), aluminum oxide (alumina), zirconium oxide, cerium oxide, titanium oxide, chromium oxide, magnesium oxide, manganese oxide, zinc oxide, and iron oxide; a nitride such as silicon nitride and boron nitride: a carbide such as silicon carbide and boron carbide; and the like. Further, the abrasive described above may be used alone or in combination of two or more. In addition, in the present description, "substantially made of X" or "substantially composed of X" with respect to the composition of the abrasive means that the ratio of X to the abrasive (purity of X) is 90% or more (preferably 95% or more, more preferably 97% or more, still more preferably 98% or more, for example 99% or more) based on the weight.

Further, among the above-mentioned abrasive, silica abrasive substantially made of silica and alumina abrasive substantially made of alumina are preferably used because such abrasive(s) can be relatively easy obtained, enable advantageous polishing of a gallium oxide substrate, and easily ensure good surface quality.

Examples of silica abrasive include colloidal silica and dry silica. Of these, the use of colloidal silica is preferred. With abrasive including colloidal silica, a high polishing removal rate and good surface quality can be suitably achieved.

Examples of colloidal silica referred to herein include silica produced using an alkali silicate-containing solution (for example, a sodium silicate-containing solution) containing an alkali metal such as Na and K and $SiO_2$ as a raw material, and silica (alkoxide method silica) produced by a hydrolysis condensation reaction of an alkoxysilane such as tetraethoxysilane or tetramethoxysilane. Examples of dry silica include silica (fumed silica) typically obtained by burning a silane compound such as silicon tetrachloride or trichlorosilane in a hydrogen flame, and silica formed by a reaction of metallic silicon with oxygen. These can be used alone or in combination of two or more.

Examples of alumina abrasive include abrasive containing $\alpha$-alumina, $\delta$-alumina, $\theta$-alumina, and $\kappa$-alumina. Among these, with alumina abrasive containing $\alpha$-alumina as a main component, a high polishing removal rate can be easily realized. In the alumina abrasive containing $\alpha$-alumina as a main component, the $\alpha$-conversion rate of alumina in the abrasive is preferably 20% or more, and more preferably 40% or more. The $\alpha$-conversion rate of alumina in the alumina abrasive is determined from the integrated intensity ratio of a (113) plane diffraction line measured by X-ray diffraction measurement. Further, alumina called fumed alumina (typically, alumina fine particles produced when an alumina salt is fired at a high temperature) based on the classification according to the production method may be used as well. In addition, alumina called colloidal alumina or alumina sol (for example, alumina hydrate such as boehmite) can also be preferably used. These can be used alone or in combination of two or more.

In the polishing composition disclosed herein, surface-modified abrasive may be used. Specifically, surface modification of the abrasive can be performed by attaching or binding a substance having a potential different from that of the abrasive surface to the abrasive surface to change the potential of the abrasive surface. There is no limitation on the substance to be used to change the potential of the abrasive surface, and for example, when the abrasive are silica abrasive, a surfactant, an inorganic acid, an organic acid, and also a metal oxide such as alumina can be used.

Further, the average primary particle diameter $D_{P1}$ of the abrasive in the polishing composition can be adjusted as appropriate. As the average primary particle diameter $D_{P1}$ of the abrasive increases, the polishing removal rate tends to improve. From such a viewpoint, the average primary particle diameter $D_{P1}$ of the abrasive may be approximately 5 nm or larger, 10 nm or larger, 15 nm or larger, 18 nm or larger, or 20 nm or larger. Further, as the average primary particle diameter $D_{P1}$ of the abrasive becomes smaller, good surface quality is more likely to be obtained. From such a viewpoint, the average primary particle diameter $D_{P1}$ of the abrasive may be approximately 1000 nm or smaller, smaller than 1000 nm, 500 nm or smaller, 200 nm or smaller, 100 nm or smaller, or 90 nm or smaller.

The average primary particle diameter $D_{P1}$ as referred to in the present description is calculated by a formula: BET diameter (nm) = 6000/(true density (g/cm$^3$) $\times$ BET value (m$^2$/g)) from a specific surface area (BET value) measured by a BET method. For example, in the case of silica abrasive, the BET diameter can be calculated from BET diameter (nm) = 2727/BET value (m$^2$/g). The specific surface area can be measured, for example, by using a surface area measuring device available from Micromeritics Instrument Corporation trade name "Flow Sorb II 2300".

Further, as the average secondary particle diameter $D_{P2}$ of the abrasive increases, the polishing removal rate tends to improve. From such a viewpoint, the average secondary particle diameter $D_{P2}$ of the abrasive may be approximately 10 nm or larger, 20 nm or larger, 30 nm or larger, or 40 nm or larger. Meanwhile, as the average secondary particle diameter $D_{P2}$ of the abrasive becomes smaller, good surface quality is more likely to be obtained. From such a viewpoint, the average secondary particle diameter $D_{P2}$ of the abrasive may be approximately 5000 nm or smaller, 1000 nm or smaller, 500 nm or smaller, 400 nm or smaller, 300 nm or smaller, or 200 nm or smaller.

The average secondary particle diameter $D_{P2}$ as referred to in the present description is the volume average particle diameter (volume average diameter D50) based on a dynamic light scattering method. The average secondary particle diameter $D_{P2}$ of the abrasive can be measured using a commercially available dynamic light scattering particle diameter analyzer, for example, using a model "UPA-UT151" available from Nikkiso Co., Ltd., or a product equivalent thereto.

The average secondary particle diameter $D_{P2}$ of the abrasive is generally equal to or larger than the average primary particle diameter $D_{P1}$ of the abrasive ($D_{P2}/D_{P1} \geq 1$), and is typically preferred to be larger than $D_{P1}$ ($D_{P2}/D_{P1} > 1$). Although not particularly limited, the polishing removal rate tends to increase as the $D_{P2}/D_{P1}$ of the abrasive increases. From such a viewpoint, the $D_{P2}/D_{P1}$ of the abrasive may be 1.05 or more, 1.1 or more, 1.2 or more, or 1.3 or more. Further, as the $D_{P2}/D_{P1}$ of the abrasive becomes smaller, good surface quality is more likely to be obtained. From such a viewpoint, the $D_{P2}/D_{P1}$ of the abrasive may be 10 or less, 5 or less, 3 or less, 2.5 or less, 2.3 or less, or 2.2 or less.

The shape (outer shape) of the abrasive may be globular or non-globular. Specific examples of non-globular abrasive include a peanut shape (that is, a peanut shell shape), a cocoon shape, a konpeito shape, a rugby ball shape, and the like.

(Water)

The polishing composition disclosed herein contains water as an essential component. As the water, ion-exchanged water (deionized water), pure water, ultrapure water, distilled water, and the like can be preferably used. The polishing composition disclosed herein may further contain an organic solvent (lower alcohol, lower ketone, etc.)

that can be uniformly mixed with water, if necessary. Usually, 90% by volume or more of the solvent contained in the polishing composition is preferably water, and 95% by volume or more (typically 99% by volume to 100% by volume) is more preferably water.

(Acid)

The polishing composition disclosed herein may contain an acid. Examples of the acids to be used include inorganic acids such as sulfuric acid, nitric acid, hydrochloric acid, chloric acid, bromic acid, phosphoric acid, phosphonic acid, phosphinic acid, and boric acid; organic acids such as acetic acid, itaconic acid, succinic acid, tartaric acid, citric acid, maleic acid, glycolic acid, malonic acid, methanesulfonic acid, formic acid, malic acid, gluconic acid, alanine, glycine, lactic acid, trifluoroacetic acid, and trifluoromethanesulfonic acid; and the like. Among the above acids, nitric acid, hydrochloric acid, chloric acid, bromic acid, and phosphoric acid can be preferably used. In addition, various acids described above can be used alone or in combination of two or more. These acids can be used as a means for adjusting the pH of the polishing composition. The polishing composition disclosed herein can be implemented in an embodiment containing at least one acid selected from the group consisting of nitric acid, hydrochloric acid, chloric acid, and bromic acid as the acid. In addition, the polishing composition disclosed herein can be implemented in an embodiment including at least phosphoric acid as the acid.

(Alkali)

Further, the polishing composition disclosed herein may contain an alkali. The alkali to be used can be exemplified by an inorganic alkali compound derived from an alkali metal, such as lithium hydroxide, sodium hydroxide, potassium hydroxide, lithium carbonate, sodium carbonate, potassium carbonate, lithium hydrogen carbonate, sodium hydrogen carbonate, and potassium hydrogen carbonate, and organic alkali compounds such as ammonia and amines. The alkalis may be used alone or in combination of two or more. These alkalis can be used as a means for adjusting the pH of the polishing composition.

(pH)

The pH of the polishing composition disclosed herein is not particularly limited. For example, the pH of the polishing composition may be 0.5 or higher, 1.0 or higher, 2.0 or higher, 3.0 or higher, or 4.0 or higher. The polishing composition disclosed herein can also be preferably implemented in an embodiment in which the pH is 5.0 or higher, 6.0 or higher, or 6.5 or higher. The pH of the polishing composition may be, for example, 13.0 or lower, 12.5 or lower, 12.0 or lower, or lower than 12.0. In some embodiments, the pH of the polishing composition may be, for example, lower than 11.0, lower than 9.5, lower than 8.0, lower than 7.0, lower than 6.0, and lower than 5.0.
In the present description, the pH of the liquid composition (polishing composition, polishing slurry, etc.) can be ascertained by using a pH meter (for example, a glass electrode type hydrogen ion concentration indicator (model number F-23) available from Horiba, Ltd.), performing three-point calibration by using a standard buffer (phthalate pH buffer, pH: 4.01 (25°C), neutral phosphate pH buffer, pH: 6.86 (25°C), and carbonate pH buffer, pH: 10.01 (25°C)), and then placing a glass electrode in the composition to be measured, and measuring the value after stabilizing for two minutes or longer.
In some embodiments of the polishing composition disclosed herein, the pH is preferably 4.0 or higher and 12.0 or lower, for example 4 or higher and lower than 12, and more preferably 4.0 or higher and lower than 12.0. When polishing using the polishing composition having a pH of 4.0 or higher and 12.0 or lower, the polishing removal rate for the gallium oxide substrate can be more advantageously improved, and good surface quality can be easily realized. Although it is not interpreted in a particularly limited manner, the reason why such an effect can be obtained is considered, for example, as follows. Gallium oxide substrates are more chemically reactive than other compound semiconductor substrates such as sapphire substrates and silicon carbide substrates and are more susceptible to the chemical properties of the polishing composition. For this reason, where polishing is performed using a strongly acidic or strongly alkaline polishing composition, the substrate surface becomes rough, which causes deterioration of the smoothness of the substrate surface after polishing and the occurrence of minute defects such as pits. It is conceivable that with the art disclosed here, by using a polishing composition having pH adjusted to 4.0 or higher and 12.0 or lower, it is possible to prevent the gallium oxide substrate surface from roughening and realize good surface quality. Further, it is considered that by adjusting the pH of the polishing composition to 4.0 or higher and 12.0 or lower, aggregation of abrasive is promoted, and a large number of secondary particles of abrasive having a suitable particle diameter are formed, and therefore the polishing removal rate can be improved. In a preferred embodiment, at least one acid selected from the group consisting of nitric acid, hydrochloric acid, chloric acid, and bromic acid is included and the pH in any of the abovementioned ranges.

In some other embodiments of the polishing composition disclosed herein, the pH is preferably 0.5 or higher and 12.0 or lower, more preferably 0.5 or higher and lower than 8, for example, can be 0.5 or higher and lower than 7.0. For example, in the polishing composition of an embodiment including at least phosphoric acid as the acid, any of the above-mentioned pH can be preferably adopted.

(Other Components)

The polishing composition disclosed herein may optionally contain an additive such as a chelating agent, a thickener, a dispersant, a surface protective agent, a wetting agent, a surfactant, a corrosion inhibitor, a preservative, and an antifungal agent, as long as the effects of the present invention are not impaired.

(Chelating Agent)

A chelating agent acts to suppress contamination of the substrate by metal impurities by forming complex ions with metal impurities that can be contained in the polishing composition and capturing the complex ions. The chelating agent may be used alone or in combination of two or more. Examples of chelating agents include aminocarboxylic acid-based chelating agents and organophosphonic acid-based chelating agents. Examples of aminocarboxylic acid-based chelating agents include ethylenediaminetetraacetic acid, sodium ethylenediaminetetraacetate, nitrilotriacetic acid, sodium nitrilotriacetate, ammonium nitrilotriacetate, hydroxyethylethylenediaminetriacetic acid, sodium hydroxyethylethylenediaminetriacetate, diethylenetriaminepentaacetic acid, sodium diethylenetriaminepentaacetate, triethylenetetraminehexacetic acid, and sodium triethylenetetraminehexacetate. Examples of organophosphonic acid-based chelating agents include 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, etane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid and $\alpha$-methylphosphonosuccinic acid. Of these, organophosphonic acid-based chelating agents are more preferable, and among them, aminotri(methylenephosphonic acid), ethylenediaminetetrakis(methylenephosphonic acid) and diethylenetriaminepenta(methylenephosphonic acid) are preferable.

(Surface Protective Agent)

The surface protective agent is adsorbed on the surface of abrasive or the substrate surface, and enhances the function of preventing defects on the substrate surface. The surface protective agent is not particularly limited as long as it is a compound that exhibits adsorptivity to the abrasive or the surface of the substrate and has an action of reducing defects on the surface of the substrate. For example, as the surface protective agent, one kind of predetermined water-soluble polymer compound may be used alone or a combination of two or more kinds thereof may be used. Examples of the water-soluble polymer compound include a polymer containing an oxyalkylene unit, a polymer containing a nitrogen atom, a polymer containing a carboxyl group, a polyvinyl alcohol-based polymer, a cellulose derivative, and a starch derivative. As a result of adding such a water-soluble polymer compound as a surface protective agent, good surface quality is likely to be obtained.

A polymer containing an oxyalkylene unit can be exemplified by polyethylene oxide (PEO), a block copolymer of ethylene oxide (EO) and propylene oxide (PO) or butylene oxide (BO), and a random copolymer of EO and PO or BO. Among them, a block copolymer of EO and PO or a random copolymer of EO and PO is preferable. The block copolymer of EO and PO can be a diblock copolymer containing a PEO block and a polypropylene oxide (PPO) block, a triblock copolymer, or the like. Examples of the triblock copolymer include a PEO-PPO-PEO type triblock copolymer and a PPO-PEO-PPO type triblock copolymer. Of these, the PEO-PPO-PEO type copolymer body is more preferable.

In a block copolymer or a random copolymer of EO and PO, the molar ratio (EO/PO) of EO and PO constituting the copolymer is preferably larger than 1, more preferably 2 or more, and even more preferably 3 or more (for example, 5 or more) from the viewpoint of solubility in water and the like.

As the polymer containing a nitrogen atom, either a polymer containing a nitrogen atom in the main chain or a polymer having a nitrogen atom in a side-chain functional group (pendant group) can be used. Examples of the polymer containing a nitrogen atom in the main chain include homopolymers and copolymers of N-acylalkyleneimine type monomers. Specific examples of the N-acylalkyleneimine type monomer include N-acetylethyleneimine and N-propionylethyleneimine. Examples of the polymer having a nitrogen atom in the pendant group include a polymer containing an N-vinyl type monomer unit. For example, homopolymers and copolymers of N-vinylpyrrolidone can be adopted. In the art disclosed herein, at least one type of homopolymer and copolymer of N-vinylpyrrolidone in which N-vinylpyrrolidone is polymerized at a ratio of 50 mol% or more is preferably used.

Examples of the polymer containing a carboxyl group include a polymer containing a (meth)acrylic acid type structural unit as a repeating unit constituting the polymer. Here, "(meth)acrylic acid" means to comprehensively refer to acrylic acid and methacrylic acid. In the polymer, from the viewpoint of solubility in water and the like, the ratio of the number of moles of the (meth)acrylic acid type structural unit to the number of moles of all repeating units is preferably 50% or more, and more preferably 80% or more, and may be 90% or more, or 95% or more. All repeating units of the carboxyl group-containing polymer may be composed substantially of (meth)acrylic acid type structural units. Among them, an acrylic acid-based polymer (polyarylic acid) in which the ratio of the number of moles of acrylic acid type structural units to the number of moles of all repeating units in the polymer is 50% or more, for example 80% or more, typically 90% or more is preferable.

In the polymer containing a carboxyl group, the carboxyl group contained in the polymer may form a salt with a cation (preferably a monovalent cation) such as a sodium ion or an ammonium ion. For example, polyacrylates such as sodium polyacrylate and ammonium polyacrylate are included in the examples of polymers having a carboxyl group.

For the purpose of adjusting the balance between water solubility and adsorptivity, the polymer containing a carboxyl group may further contain, as a repeating unit constituting the polymer, a structural unit having no carboxyl group. The polymers containing a carboxyl group may be, for example, copolymers of (meth)acrylic acid and one or two or more kinds of monomers selected from (meth)acrylic acid esters (preferably acrylic acid esters) such as ethyl (meth)acrylate, butyl (meth)acrylate, 2-ethylhexyl(meth) acrylate, 2-dimethylaminoethyl (meth)acrylate, and 2-hydroxyethyl (meth)acrylate, or salts of such copolymers.

The polyvinyl alcohol (PVA)-based polymer may be unmodified PVA (non-modified PVA, for example, polyvinyl alcohol having a saponification degree of 95% or more or 98% or more), and modified PVA which is PVA containing a VA unit and a non-VA unit. Non-modified PVA and modified PVA may be used in combination. The content of the modified PVA is, for example, preferably 50% by weight or less, more preferably 30% by weight or less, still more preferably 10% by weight or less, and may be 5% by weight or less and 1% by weight or less based on the total content of the polyvinyl alcohol-based polymer. As the polyvinyl alcohol-based polymer, polyvinyl alcohol (PVA), which is substantially composed of non-modified PVA, can be preferably adopted.

In addition, a cellulose derivative is a polymer containing a β-glucose unit as the main repeating unit. Examples of the cellulose derivative include methyl cellulose, ethyl cellulose, hydroxyethyl cellulose (HEC), methylhydroxyethyl cellulose, and the like. A starch derivative is a polymer including an α-glucose unit as a main repeating unit. Examples of the starch derivative include α-converted starch, pullulan, carboxymethyl starch, cyclodextrin, and the like.

In the art disclosed herein, the molecular weight of the water-soluble polymer used as the surface protective agent is not particularly limited. From the viewpoint of protecting the surface of the substrate and improving the polishing performance, it is preferable to increase the weight average molecular weight (Mw) of the water-soluble polymer. From such a viewpoint, the Mw may be approximately $5 \times 10^3$ or more, $1 \times 10^4$ or more, $2 \times 10^4$ or more, $2.5 \times 10^4$ or more, $3 \times 10^4$ or more, or $5 \times 10^4$ or more. Further, from the viewpoint of concentration efficiency and the like, it is preferable to reduce the weight average molecular weight (Mw) of the water-soluble polymer. From such a viewpoint, the Mw may be approximately $100 \times 10^4$ or less, $50 \times 10^4$ or less, $35 \times 10^4$ or less, or $20 \times 10^4$ or less. The Mw can be particularly preferably adopted for polyvinyl alcohol.

In the present description, values based on water-based gel permeation chromatography (GPC) (water-based, polyethylene oxide equivalent) can be adopted as the weight average molecular weights (Mw) of the water-soluble polymer compound and the surfactant. A model name "HLC-8320GPC" available from Tosoh Corporation may be used as the GPC measuring device. The measurement conditions may be as follows.

[GPC measurement conditions]
Sample concentration: 0.1% by weight
Column: TSKgel GMPWXL
Detector: differential refractometer
Eluent: 100 mM sodium nitrate aqueous solution/acetonitrile = 10 to 8/0 to 2
Flow rate: 1 mL/min
Measurement temperature: 40°C
Sample injection amount: 200 μL

Further, as the content of the water-soluble polymer compound in the polishing composition increases, good surface quality is likely to be obtained. From such a viewpoint, the content of the water-soluble polymer compound may be approximately 0.01% by weight or more, 0.05% by weight or more, 0.1% by weight or more, or 0.15% by weight or more. Further, as the content of the water-soluble polymer compound decreases, the polishing removal rate tends to increase. From such a viewpoint, the content of the water-soluble polymer compound may be 1% by weight or less, 0.7% by weight or less, 0.5% by weight or less, 0.4% by weight or less, 0.3% by weight or less, or 0.25% by weight or less.

(Surfactant)

Further, the polishing composition disclosed herein may contain a surfactant (typically, a water-soluble organic compound having an Mw of less than $5 \times 10^3$). The surfactants can contribute to improving the dispersion stability of the polishing composition. An anionic or a nonionic surfactant can be preferably adopted as the surfactant. A nonionic surfactant is more preferable from the viewpoint of low foaming property and ease of pH adjustment. Examples of the nonionic surfactants include oxyalkylene polymers such as polyethylene glycol, polypropylene glycol and polytetramethylene glycol; polyoxyalkylene adducts such as polyoxyethylene alkyl ethers, polyoxyethylene alkyl phenyl ethers, polyoxyethylene alkyl amines, polyoxyethylene fatty acid esters, polyoxyethylene glyceryl ether fatty acid esters, and polyoxyethylene sorbitan fatty acid esters; copolymers of multiple types of oxyalkylenes (for example, diblock copolymers, triblock copolymers, random copolymers, alternating copolymers); and the like. The surfactants may be used alone or in combination of two or more.

Further, as the Mw of the surfactant increases, good surface quality is likely to be obtained. From such a viewpoint, the Mw of the surfactant may be approximately 200 or more, 250 or more, 300 or more, or 500 or more. Further, as the Mw of the surfactant decreases, the filterability of the polishing composition and the cleanability of the object to be polished tend to improve. From such a viewpoint, the Mw of the surfactant may be less than $5 \times 10^3$, 4500 or less, or 4000 or less.

<Manufacture of Polishing Composition>

A method for manufacturing the polishing composition disclosed herein is not particularly limited. For example, the components to be contained in the polishing composition may be mixed using a well-known mixing device such as a blade type stirrer, an ultrasonic disperser, and a homomixer. The mode in which these components are mixed is not particularly limited, and for example, all the components may be mixed at once, or may be mixed in an appropriately set order.

The polishing composition disclosed herein may be in a one-agent type or a multi-agent type such as a two-agent type. For example, a solution A containing some of the constituent components of the polishing composition and a solution B containing the remaining components may be mixed and used for polishing. For example, it is preferable that a solution A containing abrasive and various additives and a solution B containing a pH adjusting agent such as an acid or alkali be separately prepared and mixed to obtain the pH of 4.0 or higher and lower than 12.0.

The polishing composition disclosed herein may be in a concentrated form (that is, in the form of a concentrated solution of a polishing slurry) before being supplied to the gallium oxide substrate. The polishing composition in such a concentrated form is advantageous from the viewpoint of convenience and cost reduction in production, distribution, storage, and the like. The concentration factor can be, for example, about 1.2 to 50 times in terms of volume.

The polishing composition in the form of a concentrated solution as described above can be used in an embodiment in which a polishing slurry is prepared by diluting the concentrated polishing composition at a desired timing, and the polishing slurry is supplied to a gallium oxide substrate. The dilution can typically be done by adding a solvent (for example, water) to the concentrate and mixing. When the solvent is a mixed solvent, the dilution may be performed by adding only some of the constituent components of the solvent, or the dilution may be performed by adding a mixed solvent containing those constituent components in an amount ratio different from that of the solvent. In a multi-agent type polishing composition, a polishing slurry may be prepared by diluting some of the agents and then mixing with other agents, or a polishing slurry be prepared by mixing a plurality of agents and then diluting the mixture.

At this time, the polishing removal rate tends to improve as the content of abrasive in the polishing slurry increases. From such a viewpoint, the content of abrasive in the polishing slurry may be approximately 1% by weight or more, 5% by weight or more, 7.5% by weight or more, or 10% by weight or more. As the content of abrasive in the polishing slurry decreases, it tends to be easy to obtain good surface quality. From such a viewpoint, the content may be approximately 50% by weight or less, 45% by weight or less, 40% by weight or less, 35% by weight or less, or 30% by weight or less.

<Polishing Method>

The polishing composition disclosed herein can be used for polishing a gallium oxide substrate, for example, in an embodiment including the following operations.

That is, a polishing slurry including any of the polishing compositions disclosed herein is prepared. Preparing the polishing slurry may include diluting the polishing composition. Alternatively, the polishing composition may be used as it is as a polishing slurry. Further, in the case of a multi-agent type polishing composition, the preparation of the polishing slurry can include the steps of mixing the agents, diluting one or a plurality of agents before the mixing, diluting the mixture after the mixing, and the like.

Next, the polishing slurry is supplied to the object to be polished, and polishing is performed by a conventional method. For example, the object to be polished is set in a general polishing machine, and the polishing slurry is supplied to the surface of the object to be polished (the surface to be polished) through a polishing pad of the polishing machine. Typically, the polishing pad is pressed against the surface of the object to be polished to move the two relative to each other (for example, rotational movement) while continuously supplying the polishing slurry.

According to the present description, a polishing method for polishing a gallium oxide substrate and a method for manufacturing a gallium oxide substrate using the polishing method are provided. The polishing method is characterized by including a step of polishing the surface of the gallium oxide substrate with the polishing composition disclosed herein. In a preferred embodiment, the polishing method disclosed herein includes a rough polishing step (lapping step) and a final polishing step (polishing step). The rough polishing step referred to herein is a polishing step arranged before the final polishing step (finish polishing step), and is carried out to adjust the thickness of the gallium oxide substrate. For example, in this rough polishing step, polishing is performed using a polishing composition including diamond abrasive. Further, the final polishing step referred to herein is a polishing step arranged at the very end (that is, on the most downstream side) of the polishing step performed by using the polishing composition including abrasive. The polishing method disclosed herein may include an additional step (cleaning step or preliminary polishing step) before the rough polishing step or between the rough polishing step and the final polishing step.

By performing polishing using the polishing composition disclosed herein, a gallium oxide substrate having a highly smooth surface having a surface roughness Ra [nm] of 0.1 nm or smaller can be obtained. For this reason, the polishing composition disclosed herein can be particularly preferably used in a final polishing step arranged at the very end of the polishing step. The above description is not limited to the use of the polishing composition disclosed herein in the final polishing step. That is, the polishing composition disclosed herein may be used in the rough polishing step, or may be used in both the rough polishing step and the final polishing step. Further, when a polishing step (for example, a preliminary polishing step) is arranged in addition to the rough polishing step and the final polishing step, the polishing composition disclosed here can also be used for such other polishing step.

The final polishing step can be applied to both polishing with a single-sided polishing machine and polishing with a double-sided polishing machine. In a single-sided polishing machine, the object to be polished (gallium oxide substrate) is attached to a ceramic plate with wax, or the object to be polished is held by a holder called a carrier, and one side of the object to be polished is polished by pressing a polishing pad against the one side of the object to be polished and moving (for example, rotating) the two relative to each other while supplying the polishing composition. In the double-sided polishing machine, the object to be polished is held by a holder called a carrier, and both sides of the object to be polished are polished at the same time by pressing the polishing pads against the facing sides of the object to be polished and rotating the object and the pads relative to each other while supplying the polishing composition from above.

The polishing pad to be used in the final polishing process is not particularly limited. For example, a soft polyurethane foam type, a hard polyurethane foam type, and a non-woven fabric type polishing pad can be used. Among these, a soft polyurethane foam type polishing pad can be preferably used. The soft foamed polyurethane type polishing pad is a polishing pad in which at least the side pressed against the object to be polished is made of soft foamed polyurethane, and it can be exemplified by a suede type polishing pad. Further, among the suede type polishing pads, a polishing pad having a shore A hardness of 60 or smaller can be preferably used. The Shore A hardness is a value measured using a rubber hardness tester (A type) conforming to JIS K6253 after the polishing pad is left at room temperature for 60 minutes or longer in a dry state with a humidity of 20% to 60%.

<Method for Manufacturing Gallium Oxide Substrate>

The art disclosed herein may include providing a method for manufacturing a gallium oxide substrate and a gallium oxide substrate manufactured by the method. That is, according to the art disclosed herein, a method for manufacturing a gallium oxide substrate, including a polishing step of supplying any of the polishing compositions disclosed herein to the gallium oxide substrate to polish the gallium oxide substrate, and a gallium oxide substrate manufactured by this method are provided. The manufacturing method can be carried out by suitably adopting the contents of any of the polishing methods disclosed herein. Examples

Hereinafter, some examples of the present invention will be described, but the present invention is not intended to be limited to those examples. In the following description, "%" is based on weight unless otherwise specified.

«Experiment A»

<Preparation of Polishing Composition>

(Example 1A)

A mixed solution containing colloidal silica (average primary particle diameter: 35 nm) and deionized water and having an abrasive concentration of 20% was prepared, and nitric acid was added to the mixed solution to adjust the pH to 7.0 and prepare a polishing composition of the present example.

(Example 2A)

A polishing composition according to the present example was prepared under the same conditions as in Example 1A except that colloidal silica (average primary particle diameter: 72 nm) was used.

(Example 3A)

A mixed solution containing fumed silica (average primary particle diameter: 30 nm) and deionized water and having an abrasive concentration of 40% was prepared, and hydrochloric acid was added to the mixed solution to adjust the pH to 11.5 and prepare a polishing composition of the present example.

(Example 4A)

A mixed solution including $\alpha$-alumina (average secondary particle diameter: 440 nm) and deionized water and having an abrasive concentration of 40% was prepared, and a 48% potassium hydroxide aqueous solution was added to the mixed solution to adjust the pH to 7.0 and prepare a polishing composition of the present example.

(Comparative Example 1A)

Deionized water was used as the polishing composition of the present example.

<Evaluation of Polishing removal rate>

The polishing composition according to each example was used as a polishing slurry to perform a polishing experiment on a $\beta$-gallium oxide substrate, and the polishing removal rate was evaluated. As the object to be polished, a $\beta$-gallium oxide substrate having a surface area (area of the surface to be polished) of 1.5 cm$^2$ was used, and the surface of this substrate was polished under the following polishing conditions. Then, the polishing removal rate was calculated according to the following calculation formulas (1) and (2). In the present experiment, three $\beta$-gallium oxide substrates were polished and the average value was calculated. The results are shown in Table 1.

$$(1) \text{ Polishing removal [cm]} = (\text{difference [g] in weight of gallium oxide substrate}$$

$$\text{between before and after polishing})/(\text{gallium oxide density [g/cm}^3]) (= 5.88 \text{ g/cm}^3)/(\text{area of}$$

$$\text{surface to be polished [cm}^2]) (= 1.5 \text{ cm}^2)$$

$$(2) \text{ Polishing removal rate [nm/min]} = (\text{polishing removal [cm]}) \times (10^7/\text{polishing}$$

$$\text{time } (= 30 \text{ minutes}))$$

[Polishing Conditions]

Polishing machine: Lens polishing machine available from Udagawa Optical Machines Co., Ltd.
Polishing load: 500 g/cm$^2$.
Platen rotational speed: 130 rpm.

Head (carrier) rotational speed: 130 rpm.
Polishing pad: "SURFIN SSW-1" available from Fujimi Incorporated.
Polishing slurry supply rate: 100 mL/min.
Polishing slurry temperature: 20°C.
Platen cooling water temperature: 20°C.
Polishing time: 30 min.

[Table 1]

| Table 1 | | |
|---|---|---|
| | pH | Polishing removal rate ($\mu$m/h) |
| Example 1A | 7.0 | 11.0 |
| Example 2A | 7.0 | 5.5 |
| Example 3A | 11.5 | 9.0 |
| Example 4A | 7.0 | 39.0 |
| Comparative Example 1A | 7.0 | 0.0 |

As shown in Table 1, in the polishing using the polishing compositions of Examples 1A to 4A, a better polishing removal rate could be obtained as compared with the polishing using the polishing composition of Comparative Example 1A. From this, it is understood that it is necessary to apply a load equivalent to or greater than the friction between the substrate and the polishing pad to polish the gallium oxide substrate, and it is understood that it is preferable to polish using a polishing composition containing abrasive.

«Experiment B»

<Preparation of Polishing Composition>

(Examples 1B to 4B)

Polishing compositions of Examples 1B to 4B having a pH different from that of Example 1A were prepared in the same manner as in Example 1A except that the addition amount of nitric acid was changed. The pH of each polishing composition is as shown in Table 2.

(Comparative Example 1B)

As the polishing composition of the present example, deionized water was used as in Comparative Example 1A.

<Evaluation of Polishing removal rate>

The polishing composition according to each example was used as a polishing slurry, $\beta$-gallium oxide substrates were polished under the following conditions, and the polishing removal rate was evaluated. The results are shown in Table 2.

[Polishing Conditions]

Polishing machine: single-sided polishing machine available from Engis Japan Corporation, model "EJ-380IN".
Polishing load: 280 g/cm$^2$.
Platen rotational speed: 60 rpm.
Head (carrier) rotational speed: 60 rpm.
Polishing pad: "SURFIN 019-3" available from Fujimi Incorporated.
Polishing slurry supply rate: 10 mL/min.
Polishing slurry temperature: 20°C.
Platen cooling water temperature: 20°C.
Polishing time: 30 min.

EP 3 859 768 A1

[Table 2]

| Table 2 | | |
| --- | --- | --- |
| | pH | Polishing removal rate ($\mu$m/h) |
| Example 1B | 6.7 | 4.5 |
| Example 2B | 3.0 | 3.2 |
| Example 3B | 4.0 | 4.0 |
| Example 4B | 9.8 | 3.3 |
| Comparative Example 1B | 7.0 | 0.0 |

As shown in Table 2, in the polishing using the polishing compositions of Examples 1B to 4B, a better polishing removal rate was obtained as compared with the polishing using the polishing composition of Comparative Example 1B. From this, it is also understood that it is preferable to polish the gallium oxide substrate by using a polishing composition containing abrasive.

«Experiment C»

<Preparation of Polishing Composition>

In the present experiment, the same polishing composition as in Example 1B of Experiment B was used.

<Polishing Removal>

A polishing experiment of a $\beta$-gallium oxide substrate was carried out using the polishing composition according to Example 1B as a polishing slurry. In this experiment, polishing was performed under the same conditions as in Experiment A, except that the polishing time was changed to one hour, and the polishing removal [$\mu$m] was measured 30 minutes and one hour after the start of polishing. The results are shown by the square plot of the graph in Fig. 1.

<Surface Roughness Ra>

In addition, the surface roughness Ra [nm] of the $\beta$-gallium oxide substrate was also measured 30 minutes and one hour after the start of polishing. The results are shown by the diamond-shaped plot of the graph in Fig. 1. The measurement conditions for the surface roughness Ra are as follows.
[Ra Measurement Conditions]
Evaluation device: atomic force microscope (AFM) available from Bruker Corporation.
Device model: Nanoscope V.
Viewing angle: 10 $\mu$m square.
Scanning speed: 1 Hz (20 $\mu$m /sec).
Number of measurement points per scan: 256 (points).
Number of scans: 256 (lines).
Measurement sites: 5 (measurement was performed at one location in the center of the wafer and four locations at 90° intervals on the circumference of the 1/2 radius of the wafer, and the average of the measurement results at the above five locations was recorded as Ra).
As shown in Fig. 1, in the polishing using the polishing composition of Example 1B, the polishing removal was 5.3 $\mu$m in one hour after the start of polishing, and good polishing removal rate was obtained. Further, a significant decrease in surface roughness Ra was confirmed within 30 minutes after the start of polishing, and a gallium oxide substrate having a smooth surface with a surface roughness Ra of 0.1 nm was obtained after one hour.

«Experiment D»

<Preparation of Polishing Composition>

(Examples 1D to 4D)

Polishing compositions of Examples 1D to 4D were prepared in the same manner as in Example 1A except that the type of acid to be added was changed to phosphoric acid. The pH of each polishing composition is as shown in Table 3.

(Comparative Example 1D)

As the polishing composition of the present example, deionized water was used as in Comparative Example 1A.

<Evaluation of Polishing removal rate>

The polishing composition according to each example was used as a polishing slurry, β-gallium oxide substrates were polished under the following conditions, and the polishing removal rate was evaluated. The polishing removal rate was calculated assuming that the polishing time was 60 minutes in the formula (2). The results are shown in Table 3.

[Polishing Conditions]

Polishing machine: single-sided polishing machine available from Engis Japan Corporation, model "EJ-380IN".
Polishing load: 240 g/cm$^2$.
Platen rotational speed: 60 rpm.
Head (carrier) rotational speed: 60 rpm.
Polishing pad: "SUBA 800" available from Nitta Haas, Incorporated. (nonwoven fabric type) Polishing slurry supply rate: 10 mL/min.
Polishing slurry temperature: 20°C.
Platen cooling water temperature: 20°C.
Polishing time: 60 min.

[Table 3]

| Table 3 | | |
|---|---|---|
| | pH | Polishing removal rate ($\mu$m/h) |
| Example 1D | 1.5 | 5.0 |
| Example 2D | 3.8 | 4.5 |
| Example 3D | 7.0 | 1.8 |
| Example 4D | 10.8 | 1.8 |
| Comparative Example 1D | 7.0 | 0.0 |

As shown in Table 3, in the polishing using the polishing compositions of Examples 1D to 4D, a better polishing removal rate was obtained as compared with the polishing using the polishing composition of Comparative Example 1D. From this, it is also understood that it is preferable to polish the gallium oxide substrate by using a polishing composition containing abrasive. Particularly good results were obtained in Examples 1D and 2D.
Although specific examples of the present invention have been described in detail hereinabove, these are merely examples and do not limit the scope of claims. The art described in the claims is inclusive of various changes and modifications of the specific examples illustrated above.

**Claims**

1.   A polishing composition used for polishing a gallium oxide substrate, the polishing composition comprising abrasive and water.

**2.** The polishing composition according to claim 1, wherein the abrasive include at least one selected from the group consisting of silica and alumina.

**3.** The polishing composition according to claim 1 or 2, wherein an average primary particle diameter of the abrasive is 5 nm or larger.

**4.** The polishing composition according to any one of claims 1 to 3, wherein an average primary particle diameter of the abrasive is 1000 nm or smaller.

**5.** The polishing composition according to any one of claims 1 to 4, wherein an average secondary particle diameter of the abrasive is 10 nm or larger.

**6.** The polishing composition according to any one of claims 1 to 5, wherein an average secondary particle diameter of the abrasive is 1500 nm or smaller.

**7.** The polishing composition according to any one of claims 1 to 6, further comprising an acid.

**8.** The polishing composition according to claim 7, wherein the acid includes at least one selected from the group consisting of nitric acid, hydrochloric acid, chloric acid, and bromic acid.

**9.** The polishing composition according to any one of claims 1 to 8, wherein pH of the polishing composition is 4.0 or higher and lower than 12.0.

**10.** The polishing composition according to claim 7, wherein the acid includes phosphoric acid.

**11.** The polishing composition according to claim 10, wherein pH is 0.5 or higher and smaller than 8.

**12.** A method for polishing a gallium oxide substrate, comprising supplying the polishing composition according to any one of claims 1 to 11 to a substrate to be polished to polish the substrate.

**13.** A method for manufacturing a gallium oxide substrate, comprising a polishing step of supplying the polishing composition according to any one of claims 1 to 12 to a substrate to be polished to polish the substrate.

[Fig. 1]

**INTERNATIONAL SEARCH REPORT**

| International application No. |
|---|
| PCT/JP2019/037362 |

A.  CLASSIFICATION OF SUBJECT MATTER
Int.Cl.  H01L21/304(2006.01)i, B24B37/00(2012.01)i, C09G1/02(2006.01)i,
         C09K3/14(2006.01)i

According to International Patent Classification (IPC) or to both national classification and IPC

B.  FIELDS SEARCHED

Minimum documentation searched (classification system followed by classification symbols)
Int.Cl.  H01L21/304, B24B37/00, C09G1/02, C09K3/14

Documentation searched other than minimum documentation to the extent that such documents are included in the fields searched
| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y | JP 2016-094510 A (FUJIMI INCORPORATED) 26 May 2016, claims 1-8, paragraphs [0002]-[0086] & TW 201631109 A & CN 107001914 A & KR 10-2017-0085034 A | 1, 2, 5-13<br>3-8, 10, 11 |
| X<br>Y | JP 2014-000641 A (FUJIMI INCORPORATED) 09 January 2014, claims 1-8, paragraphs [0002]-[0053] & US 2015/0166839 A1, claims 1-8, paragraphs [0002]-[0077] & CN 104395039 A & KR 10-2015-0032697 A & TW 201414821 A | 1-4, 9, 12, 13<br>3-8, 10, 11 |

☒  Further documents are listed in the continuation of Box C.     ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 25 October 2019 (25.10.2019) | 05 November 2019 (05.11.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

International application No.

PCT/JP2019/037362

C (Continuation).    DOCUMENTS CONSIDERED TO BE RELEVANT

| Category* | Citation of document, with indication, where appropriate, of the relevant passages | Relevant to claim No. |
|---|---|---|
| X<br>Y | JP 2008-105883 A (NIPPON LIGHT METAL CO., LTD.) 08 May 2008, claims 1-10, paragraphs [0008]-[0035] (Family: none) | 1, 2, 9, 12, 13<br>3-8, 10, 11 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018185526 A

- JP 2019062384 A